Europäisches Patentamt

European Patent Office

Office européen des brevets

(11) Publication number: **0 012 730**
**B1**

(12) **EUROPEAN PATENT SPECIFICATION**

(45) Date of publication of patent specification: **05.06.85**

(51) Int. Cl.⁴: **H 03 D 9/06**, H 04 B 1/26

(21) Application number: **79830050.5**

(22) Date of filing: **07.12.79**

(54) Improvement in microwave receiver converters having a hybrid waveguide structure.

(30) Priority: **19.12.78 IT 5236578**

(43) Date of publication of application:
**25.06.80 Bulletin 80/13**

(45) Publication of the grant of the patent:
**05.06.85 Bulletin 85/23**

(84) Designated Contracting States:
**BE DE FR GB NL**

(56) References cited:
**DE-A-2 423 232**
**DE-B-1 061 392**
**DE-B-1 065 026**
**DE-B-1 100 721**
**DE-B-1 155 825**
**DE-B-1 197 516**
**DE-B-1 198 868**
**GB-A-1 042 046**
**US-A-2 547 412**

(73) Proprietor: **SELENIA INDUSTRIE
ELETTRONICHE ASSOCIATE S.p.A.
Via Tiburtina, KM 12.400
I-00131 Roma (IT)**

(72) Inventor: **Ignazio, Caroli
Via Luigi Capuana, 135
I-00137 - Roma (IT)**

(74) Representative: **Gustorf, Gerhard, Dipl.-Ing.
Mühlenstrasse 1
D-8300 Landshut (DE)**

(56) References cited:
**IEEE TRANSACTIONS ON MICROWAVE
THEORY & TECHNIQUES, vol. MTT-25, no. 12,
December 1977, New York, US, YUAN: "Design
and performance analysis of an octave
bandwidth waveguide mixer", pages 1048-1054**

## Description

GB-PS 1,042,046 discloses a balanced microwave receiver converter comprising a RF input, LO input and an IF output. The RF input and LO input are waveguides having an orthogonal mode waveguide junction. The junction defines a substantially square waveguide section which is energized in two orthogonal modes by a local oscillator coupled to the LO input, and further energized by a RF wave which is fed to the RF input. Located inside the waveguide section is a pair of oppositely-poled, co-axially arranged diodes for frequency conversion. The electric field of the RF wave couples into each of the diodes in the same direction. Contrary hereto, the local oscillator wave is coupled to those diodes in such a manner the electric field thereof coupled into the diodes in opposite directions. The difference between the current in the separate diodes flows through a low pass insulating choke to the inner co-axial conductor of an IF output. The current components in the separate diodes due to the local oscillator noise cancel each other at the junction point. Although the local oscillator noise can be cancelled due to the opposite direction of the electric field as generated by the local oscillator and coupled to the respective diodes, it has been found that undesirable impedance mismatches occur when co-axial line structures are used for the balanced connections consisting of the diodes.

This reference discloses a second structure for partially overcoming the above mentioned impedance mismatch. This structure comprises orthogonally disposed waveguides for the RF input and LO input. This orthogonally disposed waveguide slightly overlap so as to form a junction region having a cruciform-shaped cross section. Said cruciform-shaped junction lowers the impedance of the waveguide for matching it to the low impedance of the coaxial lines. This structure provides a relatively good termination at the RF input with respect to its radio frequency and at the LO input with respect to the local oscillator frequency, but does not give good termination conditions of both the image frequency and the idle frequency. It is well-known in the art that a good signal-to-noise ratio can only be obtained when correctly terminating the converter at the image and idle frequencies.

DE-OS 2 423 232 discloses a balanced microwave mixer for very high frequencies comprising a cylindrical microwave resonator, to which two orthogonal H waves, namely the RF wave and the local oscillator wave are fed, wherein these orthogonal microwaves are coupled to the resonator so as to excite two orthogonal $H_{111}$ microwaves in this cylindrical resonator. The pair of diodes is located in the cylindrical cavity of the resonator in such a manner that the radio frequency from the RF input and the local oscillator frequency of the LO input are converted in these diodes to the intermediate frequency of the IF output. The respective RF microwaves and LO microwaves are coupled to the cylindrical resonator through coupling slits. These coupling slits can be regarded as band pass filters, so that this structure does not provide a correct termination at other frequencies than the RF frequency and the LO frequency, resulting in a propagation of the image frequency currents and idle frequency currents in an uncontrolled manner. Furthermore, this structure allows the uncontrolled propagation of the respective oscillations of the idle frequencies of the second and third harmonic frequency of the local oscillator with the variation of the diodes characteristics, with the working and mounting tolerances and with the variation of the local oscillator power. These undesirable properties of this prior art microwave receiver converter results in a bad signal-to-noise ratio of the intermediate frequency output signal.

The present invention is based on the technical task how to further develop a balanced microwave receiver converter in accordance with the generic clause of claim 1 having a good signal-to-noise ratio of the intermediate frequency output signal.

This technical task is solved by a balanced microwave receiver converter in accordance with the precharacterising portion of claim 1 having the features of the characterizing portion of claim 1.

The balanced microwave receiver converter in accordance with the present invention guarantees the perfect termination both at the idle frequencies and at the image frequencies. These favourable characteristics are achieved by a termination of the converter giving favourable impedances as seen from the diodes at the idle and image frequencies.

Preferred embodiments of the present invention will be described hereinafter with references to the Figures, wherein

Fig. 1 is a basic circuit diagram of a balanced converter, Fig. 2 is an equivalent electrical circuit of the converter in accordance with the present invention, in which the RF input consisting in the real circuit of a ridged waveguide, is represented here as a two wire line (14) balanced to ground.

Fig. 3 is a diagram representing a type of hybrid co-axial waveguide structure used for the realization of the converter, in which the respective RF-, LO- and IF- ports correspond to those shown in Fig. 1.

Fig. 4 is a cross-section of the converter as shown in Fig. 3, the cross-section being in a plane parallel to a line L1 of said Fig. 3.

Fig. 5 is a cross-section of the converter as shown in Fig. 3 in a plane parallel to a line L2.

Figs. 6 & 7 are equivalent circuits representing the respective matching at the radio frequency and image frequency.

Fig. 8 is a representation of the reactance $X_L$ presented by the helical line L as shown in Fig. 2 as a function of the frequency.

Fig. 9 is a representation of the ridged waveguide.

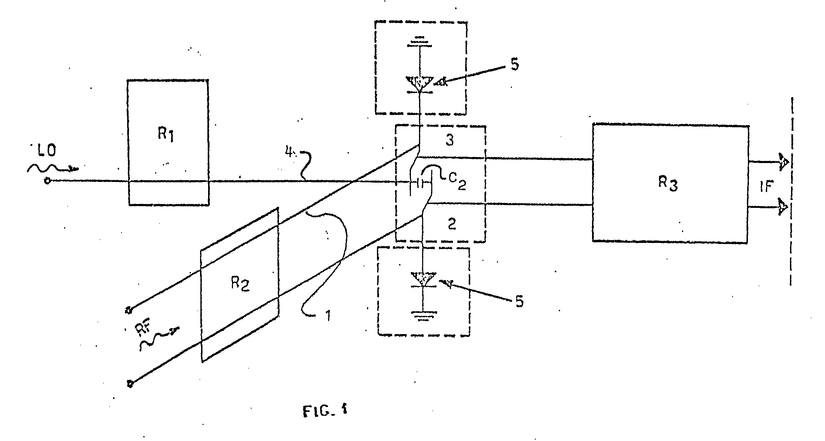

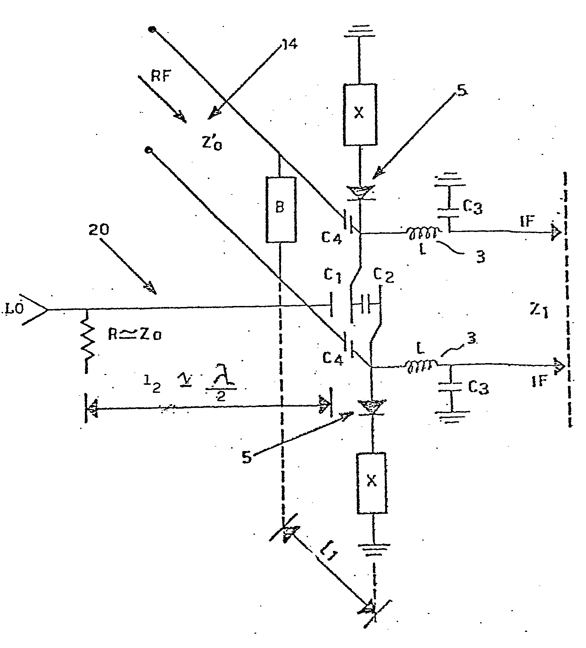

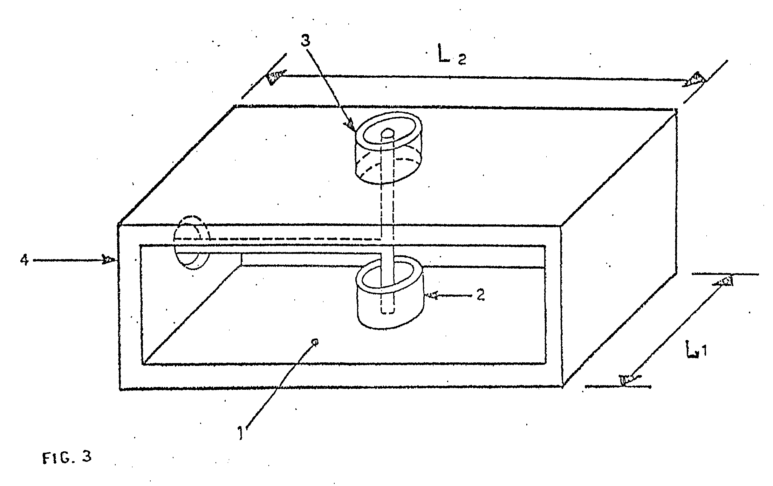

Referring now to Fig. 1, there is shown a circuit diagram of a balanced converter. The blocks identified by the reference numbers R1, R2 and R3 represent the following networks:

R1: the network matching the load to the local oscillator and reflective for the IF and RF waves.

R2: the network matching the load to the RF input and reflective to the IF wave.

R3: the network transparent up to the intermediate frequency and reflective to the LO and RF waves.

It should be emphasised that Fig. 1 is not a form of realization of the present invention, but it is valid to experts in the field, and has been introduced merely to illustrate the principles of operation, and the improvement achieved by the invention.

Further it should be underlined that this is an equivalent circuit diagram i.e. a diagram in which electronic symbology is used to indicate components (capacitors, lines, impedances, etc.) which are realized in the design of the invention with mechanical elements in a way which is well known to the technicians working in the microwave field and which will be described below.

Thus the balanced converter is formed by:

a) A four-port hybrid structure (drawn within the dotted box) in which the ports indicated by 2 and 3 have the converter diodes 5 connected as terminating loads and the ports indicated by 1 and 4 (with interchangeable functions) are fed by the RF and LO oscillations. Since port 1 is drawn with two lines balanced to earth, ports 1 and 4 are electrically decoupled from each other, while the oscillations at ports 3 and 2 are in phase with each other if coming from port 4 and in antiphase if coming from 'port 1. That allows this hybrid structure to function as a balanced converter.

b) Non-linear elements (converter diodes) indicated by 5, connected as terminating loads to ports 3 and 2 realize the conversion of the RF (radio frequency) oscillation to an IF (intermediate frequency) oscillation.

c) The networks placed at the input of the ports 1, 4 and at the IF output which have the function of guaranteeing that only the oscillation required is present on the respective ports. If we could count on a perfectly balanced hybrid structure and on terminating loads at ports 3 and 2 with perfect matching, the networks placed at port 4 or at the IF output ports would not require any electrical characteristics at the RF frequency. Since, however, the portion of the power of the RF generator connected to port 1 which is dissipated at port 4 and at the IF output port worsens the noise figure in equal measures (dB for dB) it is better, when the objective of primary importance is to render the noise figure minimum, to make the networks placed at port 4 and the IF output also reflective at the radio frequency.

d) The capacitor $C_2$ placed within the hybrid structure in the lines connection to ports 3 and 2 has the function of separating from one another the circuits for the measurements of the D.C. supply current flowing in the diodes. This has an additional function, well known in this technique, by providing separate measurements of the DC supply and immediately identifying a failed diode.

In order to achieve the main aim of the realization of this invention, i.e. the guarantee of obtaining and maintaining low noise figures, it is necessary as already pointed out to solve the problem of controlling the functioning of the structure at the image frequency and idle frequency.

The efficient control of the currents at the image frequency and idle frequencies is, as is seen, somewhat difficult since they have three different paths through which they can pass (port 1, port 2 and the IF path) in an uncontrolled manner.

Further, as far as the image frequency (which is separated from the RF oscillation frequency by only double the IF frequency) is concerned, if the converter must operate within a RF band wider than double the IF frequency there is the additional difficulty that the matching networks to the load placed in the LO and RF paths, i.e. R1 and R2, will be operating in the same frequency band as the image oscillation.

In the current technique this frequency is allowed to circulate uncontrolled but a solution to the problem can be approached by means of a separate reflecting structure placed at the input of the matching network on port 1 (R2 formed, for example, by a band pass filter at the signal frequency, by a band stop structure at the image frequency or by a selective TR in the case of a radar receiver).

Consequently, it is necessary to allow ad hoc tuning operations on varying the particular working frequency within the operational band of the converter. This problem has been confronted and solved by means of the converter which is the subject of this invention and where recourse is made to a particular form of realization which uses a co-axial waveguide network as a hybrid structure. The geometrical and mechanical characteristics of this hybrid structure will be described and illustrated below and the equivalent electrical circuit of it is shown in Fig. 2.

The hybrid "co-axial waveguide" structure which has been mentioned above as the essential element of the converter is diagrammatically constituted by a structure of the type indicated in Fig. 3 in the actual microwave technology. It is formed by a rectangular waveguide element practically consisting of a closed box in the form of a parallelepid with one side open (1 in the figure) which constitutes port 1 (RF input) in the equivalent circuit of Fig. 1. Two holes used in the alignment of the lower and upper walls allow the passage of the co-axial line and form ports 2 and 3 of the equivalent circuit, the diodes forming the loads of these ports.

A third hole made in a side wall forms port 4 for the input of the local oscillation and is crossed by the co-axial line.

Fig. 3 shows only a diagrammatic representation of the hybrid structure for illustrating the principle of operation. In the following part of the description it will be shown in detail how this has been realized in practice in this invention.

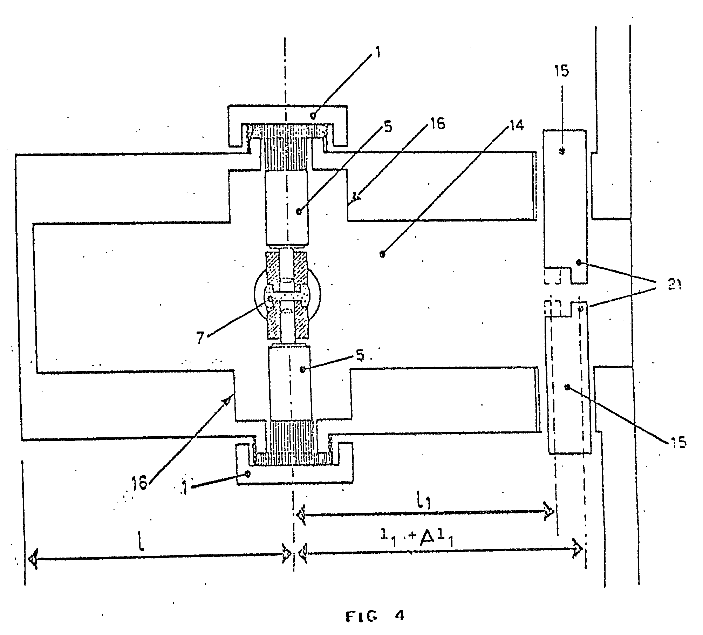

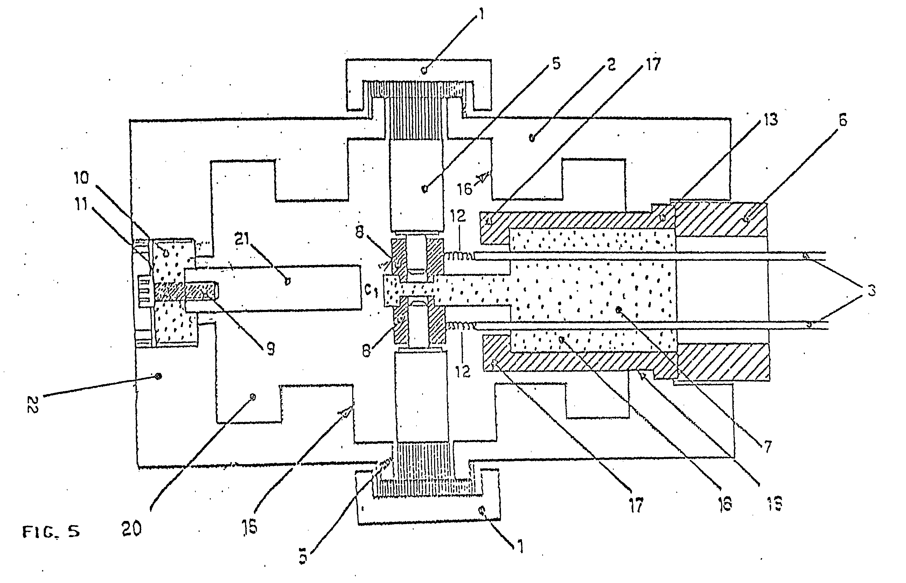

Referring to Figs. 4 and 5, we can see the structure which is the subject of the invention in the transversal and longitudinal sections of Fig. 3. The parts of the circuit resonant at IF (formed by L and C3 in Fig. 2) are not shown in Fig. 3. The operation and the circuit will now be described. Reference is made to the representation of the device as an equivalent electrical circuit and as a mechanical structure.

The RF oscillation to be converted is applied to the balanced-to-earth line having a characteristic impedance Zo'. This line is indicated with reference 14 both in Figs. 2 and 4 where it appears in cross-section as a piece of a rectangular waveguide.

It should be noted that the hybrid co-axial waveguide structure shown in the diagrammatic representation of Fig. 3 is formed by an element of parallelepiped form with flat walls which bound a space also of rectangular parallelepiped form on the inside.

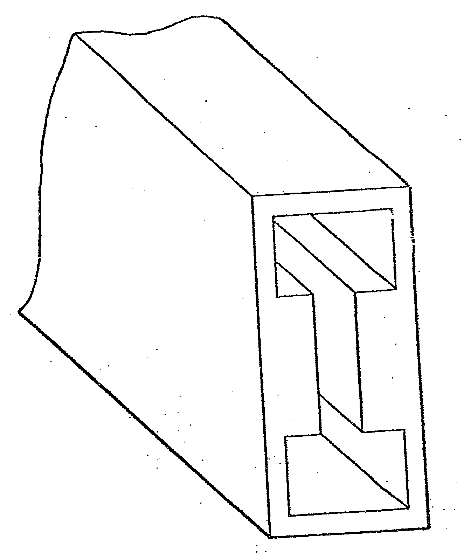

In reality this element forming the body of the waveguide presents two spaces in the central part of the upper and lower walls which give rise to the so-called loaded structure ("ridged") see Fig. 9.

The waveguide is realized in this form and made to a size such that the fundamental mode is transmitted upto the third harmonic of the LO which would not be possible with the rectangular guide. This contrivance guarantees the repetition of the terminations for the "idle" frequencies of the LO second and third harmonics because it prevents the uncontrolled propagation of the respective oscillations with the variation of the diode characteristics, with the working and mounting tolerances and the variation of LO power. It also permits both the realization of the circuit of Fig. 2 and the shortening of the electrical distance of the diodes from the rest of the circuit.

A susceptance B (see Fig. 2 and ref. 15 of Fig. 4) is placed parallel with this line.

It has been realized with a mechanical component formed by two cylindrical bodies threaded and screwed to the upper and lower walls of the waveguide. A more detailed description of this device will be given later.

This circuit in which the location of the converter diodes at a distance from the bodies 15 which can be varied from $l_1$ to $l_1+\Delta l_1$ providing both for the RF frequency matching and the reflection with the right phase of the image oscillation produced by the diodes in the conversion process.

The converter diodes are indicated by reference 5. There are of a conventional type, easily repeatable by commercial companies and formed by robust containers within which the semiconductor elements are housed. The latter are connected to the outside by means of two contacts of which one is directly fixed to the waveguide by means of a cylindrical connector and then connected to earth; the other is formed by cylinders whose electrical connection will now be described.

The active element placed inside the case shown in the figure is in reality connected to the electrode attached to earth by means of an internal conductor placed along the longitudinal axis of the container (in Fig. 4 shown dotted) and which together with the cylindrical housing 16 constitutes a piece of line realizing the reactance X of the circuit of Fig. 2, which is thus connected in series with each of the diodes on the earth side. The function of this reactance consists in controlling the idle oscillations of the third harmonic.

The other electrode of each converter diode of cylindrical form is inserted in and establishes electrical contact with a connecting element formed by a hollow cylinder 8 shown in Fig. 5, which has one end with its outside diameter reduced so that it may be inserted, as will be seen later, in a support of dielectric material 7.

The two inductors L shown in Fig. 2 which are connected directly to the two connecting elements 8 are realised by helical elements 12, their other ends being directly connected to the two lines 3 electrically in parallel and having a characteristic impedance $Z_1$ across which the IF oscillation is taken.

The value of L as will be seen later must satisfy the relationship $\omega_{IF} \cdot L \gg Z_1$. The capacitive coupling which is established between the said connecting elements 8 constitutes the capacitor, indicated as C2 in Fig. 2, which imposes mutual dependence between the voltages which appear on the elements 8. Its value must be such so as to satisfy the relationship

$$\frac{1}{\omega_{RF} \cdot C_2} \ll Zo \text{ and } Zo'.$$

Immediately at the output of the inductances L there are a pair of capacitors C3 which are connected between the ends of the said inductors that connect to the lines of impedance $Z_1$ and earth.

These capacitors are realised by means of the capacitive coupling which occurs between the lines 3 and the projections 17 provided at the coupling elements 13 above and below the dielectric support material 7.

The support material is formed by a first cylindrical body which is extended co-axially into a second body also of cylindrical form but greatly reduced in diameter which in its lower and upper faces is provided with two housings formed to hold the reduced diameter ends of the said cylindrical line 8. The support 7 is also provided with holes for the lines 3 to pass through. As previously stated the coupling elements 17 are placed above and below the said cylindrical support. They are of an elongated and curved form so as to adapt to the external surface of the cylindrical support jutting out slightly at the point where the said support reaches the zone of reduced diameter. The projections 17 referred to above occur at the point of this protrusion. At the other ends of the said coupling elements there are ribbed edges 13 which are inserted in the housings made in the body of the waveguide and which serve to block the said support mechanically like the threaded nut which holds the whole thing together.

In the circuit diagram of Fig. 2 the line of characteristic impedance Zo to which the LO oscillation is applied is marked 20. In Fig. 5 it will be seen how that line is realized by a piece of waveguide 20 crossed by the cylindrical conductor 21 which is held in position by the fixing screw 9 which functions by making electrical contact with the outside via the washer made of insulating material 10.

This line is coupled to the hybrid structure via the capacitive coupling $C_1$ which is formed between the end of the cylindrical conductor 21 and the elements 8. The resultant reactance should satisfy the relationship:

$$\frac{1}{\omega_{RF}C_1} \gg Zo$$

typically 3—5 Zo and ensure a maximum voltage for the LO oscillation on the plane of $C_1$.

A resistance of $R \approx Zo$ is placed in parallel with this line at a distance

$$1/2 \approx \frac{\lambda}{2}$$

in the range of the operating frequency of the LO.

Whenever the relationships:

$$\frac{1}{\omega_{RF}C_1} \gg Zo;$$

$$\frac{1}{\omega_{RF}C_2} \ll Zo \text{ and } Zo';$$

$$\frac{1}{\omega_{RF}C_1} \gg Z_{IF}$$

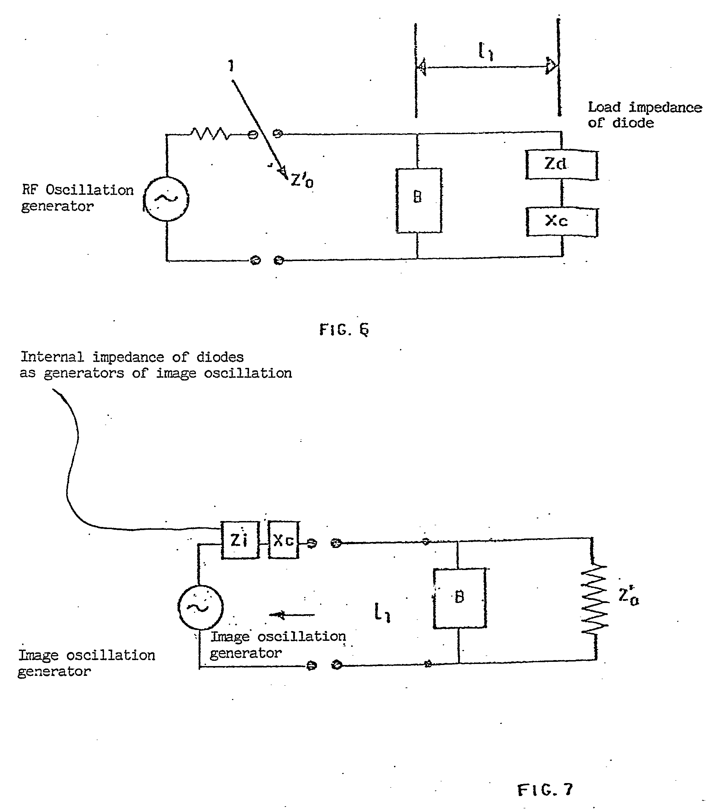

are satisfied from what has been said above it will be seen how the equivalent circuit of Fig. 2 meets the requirement, as shown in Fig. 1, of a typical network of a balanced converter. Fig. 6—8 show the mechanism controlling the idle and image oscillations and matching the diode impedance to the RF generator.

The generator of the RF oscillations applied to port 1 shows an equivalent circuit as indicated in Fig. 6 in which for simplicity only one diode is shown. It is formed by a line of impedance Zo' on which a susceptance B is placed at an electrical distance $l_1$ from the diodes that are represented as an impedance Zd in series with a network reactance.

The reactance X (see Fig. 2) placed in series with the diodes is formed as seen above, with a piece of line having a characteristic impedance Zo'' and being

$$\frac{\lambda}{4}$$

long with respect to the third harmonic idle frequency $\omega_3 = 3\omega_{RF}$.

Therefore $X = \infty$ for $\omega_3 = 3\omega_{RF}$ independent from the value of Zo''.

In fact it is $X = Zo''$ tg

$$\frac{1}{\lambda}2\pi$$

which gives $X = Zo''$ tg

$$\frac{\pi}{2} = \infty$$

independently of Zo'' for $\omega_3 = 3\omega_{RF}$.

At the frequency $\omega_{RF}$ is $X_c \approx Zo''$ tg

$$\frac{\pi}{6}$$

and therefore $X_c$ is a function of Zo''.

By varying the values of B and $X_c$ it is possible to effect the matching in relation to different values of the length $l_1$ which in its turn must be chosen for the most favourable phase of the image frequency $f_i$ in order to obtain the best termination for the image oscillation, as shown in Fig. 7, in which the diode having the impedance $Z_i$ is the generator for the image frequency.

As stated above the values of B and $l_1$ can be adjusted within certain limits by means of the regulating device 21 which will now be described.

Referring to Fig. 4, it can be seen that in the upper and lower walls of the piece of waveguide 14 which forms the RF input there are two cylindrical elements 15 screwed into the said walls by means of the threads on the cylindrical elements and also in the walls. Material has been removed from these cylindrical elements at the internal extremity of the waveguide so as to form two teeth 21 protruding from the said extremity.

The suspectance B is formed by means of the capacitive coupling which is established between the external flat surfaces of the said teeth 21.

Its value may be adjusted by suitably rotating the two threaded cylindrical elements since this varies the distance which separates the said surfaces and therefore the value of the said suspcetance.

Once the said extreme flat surfaces have been set at the desired distance, if the two cylindrical bodies are made to rotate simultaneously, this will remain unchanged but the position of the two teeth will vary with respect to the diodes and therefore the distances will vary from $l_1$ to $l_1+\Delta l_1$ (Fig. 4).

However, as stated the simultaneous variation of the values of B and $l_1$ is possible which makes it possible to use converter diodes of different families for the device i.e. to adapt it to the particular equivalent circuit for the semiconductor. Since at the image frequency the diodes become generators of this frequency with an internal impedance Zi≠Zd (Zd being the impedance presented by the diodes as terminating impedance for the RF oscillation to be converted) the equivalent circuit for the image oscillator becomes that of Fig. 7. In this figure the susceptance B and the reactance $X_c$ are shown unchanged and the image oscillation being near to the frequency of the working oscillation.

The circuit of Fig. 6 may be considered basically as a transformer which adapts the impedance of load Zd to the internal impedance of the generator Zo' (Fig. 7). At the image frequency at which the diode becomes a generator with an internal impedance Zi≠Zd the matching conditions are no longer maintained and the power available at the image frequency is not dissipated in the load (now represented by the internal impedance of the RF generator Zo').

The search for the most suitable phase for the load impedance seen from the diodes at the image frequency in order to improve the noise figure is sought as the most favourable value of distance $l_1$.

As far as the problem of the idle frequency at the third harmonic is concerned, with reference to Fig. 2, it may be seen that as X=∞ for $\omega_3=3\omega_{RF}$ the circulation of third harmonic currents is completely prevented.

Now we will examine the problem of idle frequencies at the second harmonic. Referring to Fig. 2, in which the diodes are seen as generators of second harmonic idle frequencies and the RF, LO and IF ports are terminated by the relative loads, it will be seen that if the path formed by the inductance L and the capacitor $C_3$ has zero reactance the control of the circulation of the second harmonic is assured.

If the inductance L is formed with a helical line we may take advantage of the behaviour of the reactance of this line as a function of the frequency to simultaneously bring about the conditions of:

— negligible reactance at the IF frequency
— high reactance at the RF and LO frequencies
— low reactance at the second harmonic idle frequency

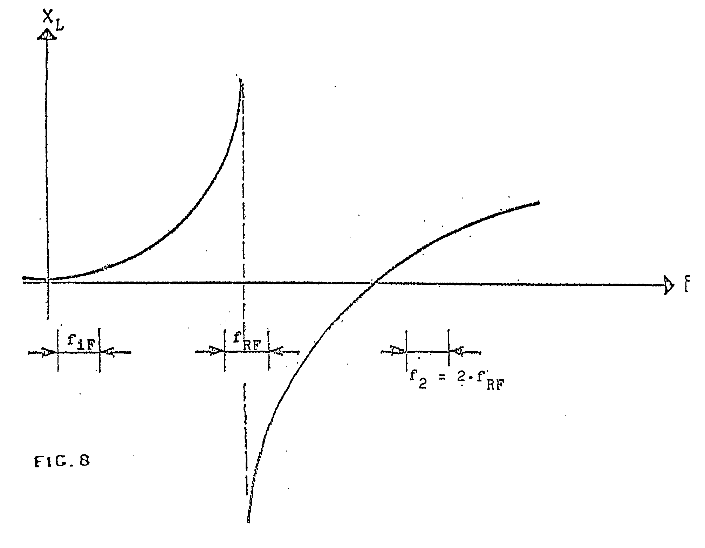

In fact the behaviour of the reactance as a function of the frequency in a helical line is indicated in Fig. 8 in which the desired conditions are seen to be realized.

The capacitance $C_3$, indicated in Fig. 2, which practically has no effect on the behaviour of the reactance in the range of IF, RF and LO frequencies serves to adjust the minimum reactance at frequency f2. Using the criteria explained above, a converter operating in the range of 3 GHz and with a SWR 1,8 in a band >100 MHz has been realized. The converter has been terminated in an IF amplifier with $F_{IF}$ 2dB nom..

The values of the noise figure measured, without resorting to electrical adjustments on the varying of the particular working frequency within the band and with varied pairs of commercial diodes, are contained within a range of 5 to 5,5 dB using schottky type diodes.

**Claims**

1. Balanced microwave receiver converter comprising:

a RF input (14) being a waveguide, a LO input (20), an IF output (3) and two converters diodes (5) for frequency conversion, the converter having a hybrid coaxial-waveguide structure, characterized in

that the RF input (14) is a ridged waveguide having an impedance Zo',

that the LO input (20) is a line having an impedance Zo, that the IF output (3) is a two-wire line having an impedance $Z_1$,

that the respective first ends of the converter diodes (5) are coupled to the RF input (14) by means of a fourth capacitive coupling ($C_4$, $C_4$),

that the respective first ends of the converter diodes (5) are connected to each other by means of a second capacitive coupling ($C_2$),

that the respective second ends of the diodes (5) are connected to ground via reactances (X, X),

that the LO input (20) is coupled to the respective first ends of the diodes via a first capacitive coupling ($C_1$),

that both of the two wires of the IF output (3) are connected to the respective first ends of the diodes by means of two helical inductive lines (L), each of these helical lines (L) has a neglectible reactance at the IF frequency, high reactances at RF and LO frequencies and a low reactance at the second harmonic idle frequency,

that an adjustable susceptance (B) is disposed in the waveguide of the RF input (14) parallel to the RF input at an adjustable distance $l_1+\Delta l_1$ from the diodes (5), and

that a resistance (R) having the value about Zo is disposed in the LO input line (20) in parallel with the first capacitive coupling ($C_1$) at a distance of $l_2$ from the diodes (5), wherein $l_2$ equals $\lambda_{LO}/2$.

2. Balanced microwave receiver converter as claimed in claim 1, characterized in

that the structure is a parallelepiped waveguide structure, the first side (1) thereof being open and forming a RF wave input,

that a device (15) forming the susceptance (B) is arranged at the first open side (1) at the distance $l_1$

from the diodes (5), which are secured to opposite upper and lower sides of the parallelepiped waveguide structure,

that a second side (4) thereof orthogonal to the first side (1) has an opening allowing an insulating block (7) to extend through it, the insulating block (7) containing the two IF output wires (3) being connected to the diodes by means of two helical lines (L),

that a third capacitive coupling ($C_3$) is formed between the junctions of the respective wire (3) with the respective helical line (L) and ground in the proximity of the respective junction by means of two coupling members (17) made of projections,

that the diodes (5) are arranged co-axially, the respective second ends thereof being connected to the respective upper and lower sides of the waveguide through the reactances (X), the respective first ends being insulated from each other by means of a projection of the insulating block (7),

that the third side of the waveguide structure opposite to the second one is a hole for securing a cylindrical element (21) which constitutes together with a piece of the waveguide having the length $l_2$ the LO input line having the impedance Zo.

3. Balanced microwave receiver converter as claimed in claim 1 or 2, characterized in that the device (15) constituting said susceptance (B) comprises two cylindrical elements (15) having threads for securing them to the waveguide structure at one end thereof and further having a tooth (21) asymmetrical with respect to their axes at their respective other ends, that these elements (15) extend in vertical direction in said RF input line (14) while being co-axially disposed to each other, and that these elements (15) define the distance $l_1$ between their axes and that of the diodes (5).

4. Balanced microwave receiver converter as claimed in one of claims 1—3, characterized in that said reactances (X) located between the second end of the diodes (5) and ground are formed by a piece of co-axial line (5, 16), wherein an outer cylindrical wall (16) thereof is formed by a cavity hollowed out of the upper and lower side of the waveguide structure, and that said co-axial line (5, 16) has a length of $\lambda/4$, wherein $\lambda$ is the wave length at the third harmonic idle frequency.

5. Balanced microwave receiver converter as claimed in one of claims 1—4, characterized in that the second capacitive coupling ($C_2$) is realised by the space separating two cylindrical elements which are secured to the respective first ends of the diodes (5), wherein said cylindrical elements are fixedly secured in seats provided in the projection of said insulating block (7).

**Patentansprüche**

1. Gegentakt-Mikrowellen-Empfängerwandler mit folgenden Merkmalen:

einem RF-Eingang (14), der ein Wellenleiter ist, einem LO-Eingang (20), einem IF-Ausgang (3) und zwei Wandlerdioden (5) zur Frequenzwandlung, wobei der Wandler eine hybride Koaxial-Wellenleiter-Struktur aufweist, dadurch gekennzeichnet,

daß der RF-Eingang (14) ein Steg-Wellenleiter ist, der eine Impedanz Zo' hat,

daß der LO-Eingang (20) eine Leitung ist, die eine Impedanz Zo hat,

daß der IF-Ausgang (3) eine Zwei-Draht-Leitung ist, die eine Impedanz $Z_1$ hat,

daß die jeweiligen ersten Enden der Wandlerdioden (5) an den RF-Eingang (14) mittels einer vierten kapazitiven Kopplung ($C_4$, $C_4$) angeschlossen sind,

daß die jeweiligen ersten Enden der Wandlerdioden (5) miteinander mittels einer zweiten kapazitiven Kopplung ($C_2$) verbunden sind,

daß die jeweiligen zweiten Enden der Dioden (5) mittels Widerständen (X, X) mit Masse Verbunden sind,

daß der LO-Eingang (20) an die jeweiligen ersten Enden der Dioden über eine erste kapazitive Kopplung ($C_1$) angeschlossen ist,

daß jeder der beiden Drähte des IF-Ausganges (3) an die jeweiligen ersten Enden der Dioden mittels zweier schraubenförmiger, induktiver Leitungen (L) angeschlossen ist, wobei jede dieser schraubenförmigen Leitungen (L) eine vernachlässigbare Reaktanz bei der IF-Frequenz hat, hohe Reaktanzen bei RF- und LO-Frequenzen und eine niedrige Reaktanz bei der zweiten harmonischen Leerlauffrequenz hat,

daß eine einstellbare Suszeptanz (B) in dem Wellenleiter des RF-Eingangs (14) parallel zu dem RF-Eingang und in einer einstellbaren Entfernung $l_1 + \Delta l_1$ von den Dioden (5) angeordnet ist, und

daß ein Widerstand (R) mit einem Wert, der etwa Zo beträgt, in der LO-Eingangsleitung (20) parallel zu der ersten kapazitiven Kopplung ($C_1$) mit einer Entfernung $l_2$ von den Dioden (5) angeordnet ist, wobei $l_2$ gleich $\lambda_{LO}/2$ ist.

2. Gegentakt-Mikrowellen-Empfängerwandler nach Anspruch 1, dadurch gekennzeichnet, daß die Struktur eine Parallelepiped-Wellenleiterstruktur ist, deren erste Seite (1) offen ist und den RF-Welleneingang bildet,

daß ein Gerät (15), das die Suszeptanz (B) bildet, an der ersten offenen Seite (1) mit der Entfernung $l_1$ von den Dioden (5) angeordnet ist, die an den entgegengesetzten oberen und unteren Seiten der Parallelepiped-Wellenleiterstruktur befestigt sind,

daß deren zweite Seite (4), die senkrecht auf der ersten Seite (1) steht, eine Öffnung aufweist, durch die sich ein isolierender Block (7) erstreckt, wobei der isolierende Block (7) zwei IF-Ausgangsleitungen (3) enthält, die an die Dioden mittels zweier schraubenförmiger Leitungen (L) angeschlossen sind,

daß eine dritte kapazitive Kopplung ($C_3$) zwischen den Anschlußpunkten der jeweiligen Drähte (3) mit den jeweiligen schraubenförmigen Leitungen (L) und Masse in der Nähe der jeweiligen Anschlußpunkte mittels zweier Kopplungsglieder (17) gebildet wird, die aus Vorsprüngen bestehen,

daß die Dioden (5) koaxial angeordnet sind, wobei die jeweiligen zweiten Enden der Dioden an den jeweiligen oberen und unteren Seiten des Wellenleiters über die Reaktanzen (X) angeschlossen sind, wobei die jeweiligen ersten Enden voneinander mittels eines Vorsprunges des isolierenden Blockes (7) isoliert sind, und

daß die dritte Seite der Wellenleiterstruktur, die gegenüber der zweiten Seite liegt, ein Loch zum Befestigen eines zylindrischen Elementes (21) ist, das zusammen mit einem Stück des Wellenleiters, das die Länge $l_2$ hat, die LO-Eingangsleitung mit der Impedanz Zo bildet.

3. Gegentakt-Mikrowellen-Empfängerwandler nach Anspruch 1 oder 2, dadurch gekennzeichnet,

daß das Gerät (15), das die Suszeptanz (B) bildet, zwei zylindrische Elemente (15) aufweist, die Gewinde zu ihrer Befestigung mit der Wellenleiterstruktur an deren einen Ende aufweisen, und ferner einen Zahn (21) haben, der asymmetrisch bezüglich ihrer Achsen an ihren jeweiligen anderen Enden liegt,

daß sich diese Elemente (15) in einer vertikalen Richtung in die RF-Eingangsleitung (14) erstrecken, während sie koaxial zueinander angeordnet sind, und

daß diese Element (15) die Entfernung $l_1$ zwischen ihren Achsen und derjenigen der Dioden (5) festlegen.

4. Gegentakt-Mikrowellen-Empfängerwandler nach einem der Ansprüche 1 bis 3, dadurch gekennzeichnet,

daß die Reaktanzen (X), die zwischen dem zweiten Ende der Dioden (5) und Masse angeordnet sind, durch ein Stück einer koaxialen Leitung (5, 16) gebildet werden, deren äßere zylindrische Wand (16) durch einen Hohlraum gebildet wird, der aus der oberen und unteren Seite der Wellenleiterstruktur ausgehöhlt ist, und

daß die koaxiale Leitung (5, 16) eine Länge von λ/4 hat, wobei λ die Wellenlänge der dritten harmonischen Leerlauffrequenz ist.

5. Gegentakt-Mikrowellen-Empfängerwandler nach einem der Ansprüche 1 bis 4, dadurch gekennzeichnet,

daß die zweite kapazitive Kopplung ($C_2$) durch den Hohlraum gebildet wird, der die beiden zylindrischen Elemente trennt, die an den jeweiligen ersten Enden der Dioden (5) befestigt sind, wobei die zylindrischen Elemente auf feste Weise in Sitzen befestigt sind, die in dem Vorsprung des isolierenden Blockes (7) vorgesehen sind.

**Revendications**

1. Changeur de fréquence équilibré pour récepteur microondes comprenant:

une entrée radiofréquence (14) sous forme d'un guide d'onde, une entrée LO basse impédance (20), une sortie moyenne fréquence (3) et deux diodes de conversion (5) pour conversion de fréquence, le convertisseur ayant une structure hybride guide d'onde/coaxial, caractérisé par le fait:

que l'entrée radiofréquence (14) est un guide d'onde à saillies intérieures d'impédance Zo',

que l'entrée LO (basse température) (20) est une ligne d'impédance Zo,

que la sortie moyenne fréquence (3) est une ligne bifilaire d'impédance $Z_1$,

que les premières extrémités respectives des diodes de conversion (5) sont couplées à l'entrée radiofréquence (14) par un quatrième couplage capacitif ($C_4$, $C_4'$),

que les premières extrémités respectives des diodes de conversion (5) sont connectées les unes aux autres par un second couplage capacitif ($C_2$),

que les secondes extrémités respectives des diodes (5) sont connectées à la terre par l'intermédiaire des réactances (X, X),

que l'entrée LO basse impédance (20) est couplée aux premières extrémités respectives des diodes par l'intermédiaire d'un premier couplage capacitif ($C_1$),

Que les deux fils de la sortie moyenne fréquence (3) sont connectés aux premières extrémités respectives des diodes au moyen de deux lignes inductives hélicoïdales (L) dont chacune présente une réactance négligeable à la moyenne fréquence, des réactances élevées en radiofréquence et à la fréquence LO, et une faible réactance à la seconde fréquence harmonique réactive,

qu'une susceptance réglable (B) est disposée dans le guide d'onde de l'entrée radiofréquence (14) en parallèle sur l'entrée radiofréquence à une distance réglable $l_1 + \Delta l_1$ des diodes (5), et qu'une résistance (R) dont la valeur est proche de Zo, est montée dans la ligne d'entrée basse impédance LO (20) en parallèle sur le premier couplage capacitif ($C_1$) à une certaine distance $l_2$ des diodes (5), et où $l_2$ est égal à $\lambda_{LO}/2$.

2. Changeur de fréquence équilibré pour récepteur microondes selon la revendication 1, caractérisé par le fait:

que sa structure est celle d'un guide d'ondes à tubes parallèles dont le premier côté (1) est ouvert et constitue une entrée pour onde radiofréquences,

qu'un dispositif (15) constituant la susceptance (B) est disposée sur le premier côté ouvert (1) à la distance $l_1$ des diodes (5) qui sont fixées sur les côtés opposés supérieur et inférieur de la structure du guide d'ondes à tubes parallèles,

qu'un second côté (4) de ce guide, orthogonal au premier côté (1), présente une ouverture permettant le passage d'un block isolant (7), ce bloc isolant (7) contenant les deux fils de sortie moyenne fréquence (3) connectés aux diodes par les deux lignes hélicoïdales (L),

qu'on troisième couplage capacitif ($C_3$) est formé entre les jonctions du fil respectif (3) avec la ligne respective hélicoïdale (L) et la terre à proximité de la jonction respective au moyen de deux éléments de couplage (17) constitués par des saillies,

que les diodes (5) sont disposées coaxialement, les seconds extrémités respectives de ces diodes étant connectées aux côtés respectifs supérieur et inférieur du guide d'onde par les réactances (X), les premières extrémités respectives étant isolées les unes des autres par une saillie du bloc isolant (7),

que le troisième côté de la structure du guide d'onde opposé au second côté est un trou servant, à fixer un élément cylindrique (21) qui constitue, avec un élément du guide d'ondes de longueur $l_2$, la sortie basse impédance LO ayant l'impédance Zo.

3. Changeur de fréquence équilibré pour récepteur microondes selon la revendication 1 ou 2, caractérisé par le fait que le dispositif (15) constituant ladite susceptance (B) comprend deux éléments cylindriques (15) filetés pour permettre leur fixation à la structure du guide d'onde à une extrémité de ce dernier, et présentant en outre une dent (21) qui est asymétrique par rapport à leurs axes à leurs autres extrémités respectives, que ces éléments (15) s'étendent dans le sens vertical dans ladite ligne d'entrée radiofréquences (14) tout en étant disposés coaxialement l'un à l'autre, et que ces éléments (15) définissent la distance $l_1$ séparant leurs axes et celui des diodes (5).

4. Changeur de fréquence équilibré pour récepteur microondes selon l'une des revendications 1 à 3, caractérisé par le fait que lesdites réactances (X) montées entre le seconde extrémité des diodes (5) et la terre sont constituées par un morceau de ligne coaxiale (5, 16, dans laquelle une paroi cylindrique extérieure (16) est formée par une cavité pratiquée dans le côté supérieur et le côté inférieur de la structure du guide d'ondes, et que ladite ligne coaxiale (5, 16) a une longueur de $\lambda/4$, dans laquelle $\lambda$ est la longueur d'onde à la troisième fréquence harmonique réactive.

5. Changeur de fréquence équilibré pour récepteur microondes selon l'une des revendications 1 à 4, caractérisé par le fait que le second couplage capacitif ($C_2$) est obtenu par l'espacement séparant deux éléments cylindriques qui sont fixés aux premières extrémités respectives des diodes (5), et dans lequel lesdits éléments cylindriques sont fixés à demeure dans des évidements pratiques dans la saillie dudit bloc isolant (7).

FIG. 5

FIG. 2

$L_2$

3

$L_1$

4

2

1

FIG. 3

FIG 4

FIG. 5

FIG. 6

Load impedance
of diode

Internal impedance of diodes
as generators of image oscillation

FIG. 7

FIG. 8

FIG. 9